# EUROPEAN PATENT APPLICATION

(11) **EP 0 724 330 A1**
(43) Date of publication of application: **31.07.1996**
(21) Application number: 96100925.5
(22) Date of filing: 23.01.1996
(51) Int. Cl.: H03H 2/00

(54) **Signal-to-noice enhancer**

(30) Priority: 24.01.1995 JP 28643/95
(71) Applicant: MURATA MANUFACTURING CO., LTD., Nagaokakyo-shi Kyoto-fu 226 (JP); NIPPON HOSO KYOKAI, Tokyo 150-01 (JP)
(72) Inventor: Okada, Takekazu, c/o Murata Manuf. Co., Ltd., Nagaokakyo-shi, Kyoto-fu (JP); Shinmura, Satoru, c/o Murata Manuf. Co., Ltd., Nagaokakyo-shi, Kyoto-fu (JP); Kanaya, Fumio, c/o Murata Manuf. Co., Ltd., Nagaokakyo-shi, Kyoto-fu (JP); Ichiguchi, Shinichiro, c/o Murata Manuf. Co., Ltd., Nagaokakyo-shi, Kyoto-fu (JP); Nomoto, Toshihiro, c/o NHK Hosogijutsukenkyusyo, Setagaya-ku, Tokyo 157 (JP)
(74) Representative: Schoppe, Fritz, Dipl.-Ing.

(57) **Abstract**

A signal-to-noise enhancer 10 which can obtain a good enhancement characteristic readily includes a magnetostatic wave element 30 which in turn includes a strip GGG substrate 32. A YIG thin film 34 as a ferrimagnetic substrate is formed on one main surface of the GGG substrate 32. The magnetostatic wave element 30 is disposed on four transducers 16a through 16d. Then, a first magnetostatic wave filter is composed of the two transducers 16a and 16b, one end portion 30a of the magnetostatic wave element 30 and the like and a second magnetostatic wave filter is composed of the other two transducers 16c and 16d, another end portion 30b of the magnetostatic wave element 30 and the like.

## Description

### BACKGROUND OF THE INVENTION

### Field of the Invention

The present invention relates to a signal-to-noise enhancer and more particularly to a signal-to-noise enhancer, having a first magnetostatic wave filter for limiting an amplitude of a main signal within an input signal and a second magnetostatic wave filter for passing the main signal, for improving a (signal-to-noise) ratio of the main signal to noise within the input signal. It is used for receiving a satellite broadcasting signal for example.

### Description of the Related Art

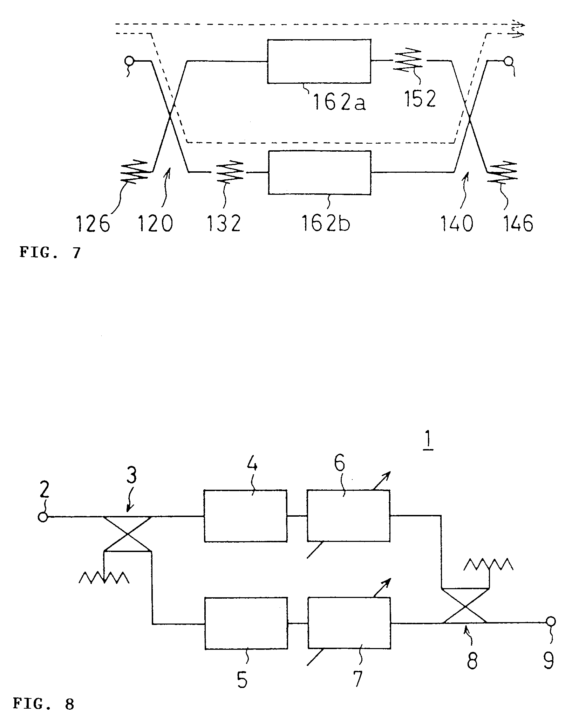

One example of a conventional signal-to-noise enhancer is disclosed in Japanese Patent Laid-open No. Hei. 4-123502. FIG. 8 is a circuit diagram showing an example of such conventional signal-to-noise enhancer. The signal-to-noise enhancer 1 shown in FIG. 8 includes an input terminal 2, which is connected to an input end of a directional coupler 3 as a divider. The directional coupler 3 divides an input signal applied to the input terminal 2 into a high-level signal which is almost in the same level with the input signal and a low-level signal which is attenuated by about 30dB for example.

Two output ends of the directional coupler 3 are connected to input ends of two magnetostatic wave filters 4 and 5 utilizing a magnetostatic surface wave mode, respectively. These magnetostatic wave filters 4 and 5 have the same frequency-selective nonlinear amplitude limiting characteristics. The frequency-selective nonlinear amplitude limiting characteristic means a characteristic wherein even if a signal of a frequency f1 is limited in excess of a saturation level, a signal of a frequency f2 is not limited when the signal of the frequency f2 different from the frequency f1 has the saturation level or less. That is, the frequency-selective nonlinear amplitude limiting characteristic means a characteristic wherein the limiting by a saturation operation caused when a signal exceeds a saturation level takes place independently in each frequency. One magnetostatic wave filter 4 is used as a limiter for limiting an amplitude of a high-level main signal in the high-level signal output from the directional coupler 3. Also, the other magnetostatic wave filter 5 is used for passing a low-level signal output from the directional coupler 3.

An output end of the magnetostatic wave filter 4 is connected to an input end of an attenuator 6. The attenuator 6 attenuates a level of a signal output from the magnetostatic wave filter 4. An output end of the other magnetostatic wave filter 5 is connected to an input end of a delay line 7. The delay line 7 delays a phase of a signal output from the magnetostatic wave filter 5. Furthermore, an output end of the attenuator 6 and that of the delay line 7 are connected to two input ends of a directional coupler 8 as an combiner, respectively. The directional coupler 8 attenuates a level of a signal output from the attenuator 6 and combines the signal whose level has been attenuated and a signal output from the delay line 7. An output end of the directional coupler 8 is connected to an output terminal 9.

Thus, in the signal-to-noise enhancer 1 described above, a first signal path is composed of the directional coupler 3, the magnetostatic wave filter 4, the attenuator 6 and the directional coupler 8 and a second signal path is composed of the directional coupler 3, the magnetostatic wave filter 5, the delay line 7 and the directional coupler 8 between the input terminal 2 and the output terminal 9.

In the signal-to-noise enhancer 1, when an input signal including a high-level main signal and a low-level noise different from the main signal in frequency and whose level is low is applied to the input terminal 2, the input signal is divided by the directional coupler 3 into a high-level signal which is almost the same level with the input signal and a low-level signal which is attenuated by, for example, 30 dB. At this time, the high-level signal includes a high-level main signal and a low-level noise different from each other in frequency and the low-level signal includes a low-level main signal and a low-level noise different from each other in frequency.

In the magnetostatic wave filter 4, although the main signal in the high-level signal is amplitude limited because its level is high, the noise in the high-level signal is not amplitude limited because the noise is different from the main signal in frequency and its level is low. On the other hand, in the magnetostatic wave filter 5, the main signal and the noise in the low-level signal are not amplitude limited as their level is low. By the way, the high-level signal and the low-level signal are slightly attenuated in level, respectively, by insertion loss in the magnetostatic wave filters 4 and 5.

Also, the level of the signal output from the magnetostatic wave filter 4 is attenuated by the attenuator 6 and the phase of the signal output from the other magnetostatic wave filter 5 is delayed by the delay line 7. Then, the level of the signal output from the attenuator 6 is attenuated by the directional coupler 8 and the signal whose level has been attenuated and the signal output from the delay line 7 are combined. At this time, the level of the signal output from the magnetostatic wave filter 4 is attenuated by the attenuator 6 and the phase of the signal output from the magnetostatic wave filter 5 is delayed by the delay line 7 so that noises in the two signals combined by the directional coupler 8 become equal in levels and opposite in phases. Thus, the noise which has passed the first signal path including the magnetostatic wave filter 4 and the noise which has passed the second signal path including the magnetostatic wave filter 5 are offset in the directional coupler 8. Although the main signal which passes the first signal path is amplitude limited by the magnetostatic wave filter 4, the main signal which passes the second signal path is not amplitude limited by the magnetostatic wave filter 5. As a result, the main signal having the level corresponding to the amplitude limited level is obtained from the output end of the directional coupler 8 or the output terminal 9. Accordingly, the signal-to-noise ratio of the input signal is improved by the signal-to-noise enhancer 1.

In the conventional signal-to-noise enhancer 1, two ferrimagnetic substrates such as a YIG thin film are used for the magnetostatic wave filters 4 and 5. The ferrimagnetic substrates such as the YIG thin films are formed many by forming a wafer by liquid-phase-growing a ferrimagnetic material such as YIG and by cutting the wafer. At this time, material characteristics such as a gyromagnetic resonance linewidth ΔH and saturation magnetization 4πMs of the two ferrimagnetic substrates may differ significantly depending on portions of the wafer to be cut. As a result, the material characteristics of two ferrimagnetic substrates differ in may cases.

Further, because it is difficult to arrange the ferrimagnetic substrates such as those two YIG thin films in the same direction with respect to a direction of a magnetic field, it is difficult to apply the same magnetic field.

Because the material characteristics of two ferrimagnetic substrates are often different and it is difficult to apply the same magnetic field to the two ferrimagnetic substrates as described above, it is difficult to construct two magnetostatic wave filters having the same input/output characteristics and it is difficult to obtain a good enhancement characteristic by the prior art signal-to- noise enhancer 1. Beside that, because two ferrimagnetic substrates have to be formed in prior art signal-to-noise enhancer 1, its productivity is also bad.

Accordingly, it is a primary object of the present invention to provide a signal-to-noise enhancer which can readily obtain a good enhancement characteristic.

### SUMMARY OF THE INVENTION

A signal-to-noise enhancer of the present invention comprising a first magnetostatic wave filter for limiting an amplitude of a main signal within an input signal and a second magnetostatic wave filter for passing the main signal is characterized in that a ferrimagnetic substrate used for the first magnetostatic wave filter and a ferrimagnetic substrate used for the second magnetostatic wave filter are formed in a body so as to extend in the same direction with a propagation direction of magnetostatic waves in the first magnetostatic wave filter and the second magnetostatic wave filter.

In the signal-to-noise enhancer of the present invention, it is preferable to dispose two transducers of the first magnetostatic wave filter at an interval on one end side of the ferrimagnetic substrate with respect to the longitudinal direction thereof, to dispose two transducers of the second magnetostatic wave filter at an interval on the other end side of the ferrimagnetic substrate with respect to the longitudinal direction thereof and to form a magnetostatic wave absorbing member for absorbing magnetostatic wave at the middle portion of the ferrimagnetic substrate with respect to the longitudinal direction thereof by the reason described later.

Further, the signal-to-noise enhancer of the present invention comprises a divider, provided in the pre-stage of the first magnetostatic wave filter and the second magnetostatic wave filter, for dividing the input signal into a first signal and a second signal, outputting the first signal to the first magnetostatic wave filter and outputting the second signal to the second magnetostatic wave filter; a combiner, provided in the post-stage of the first magnetostatic wave filter and the second magnetostatic wave filter, for combining two signals of the signal output from the first magnetostatic wave filter and the signal output from the second magnetostatic wave filter; level adjusting means for equalizing levels of noises within the two signals combined by the combiner; and phase adjusting means for adjusting phases of noises within the two signals to be opposite from each other. At this time, the level adjusting means includes a first attenuator provided between the divider and the second magnetostatic wave filter and a second attenuator provided between the first magnetostatic wave filter and the combiner and the phase adjusting means includes a phase shifter provided between the second magnetostatic wave filter and the combiner.

Further, a signal-to-noise enhancer of the present invention comprises a first hybrid set, provided in the pre- stage of the first magnetostatic wave filter and the second magnetostatic wave filter, for dividing the input signal into a first signal and a second signal having a first phase difference in a wide bandwidth, outputting the first signal to the first magnetostatic wave filter and outputting the second signal to the second magnetostatic wave filter; a second hybrid set, provided in the post-stage of the first magnetostatic wave filter and the second magnetostatic wave filter, for combining two signals of the signal output from the first magnetostatic wave filter and the signal output from the second magnetostatic wave filter with a second phase difference in a wide bandwidth; and level adjusting means for equalizing levels of noises within the two signals combined by the second hybrid set; and a sum of the first phase difference and the second phase difference is (2n + 1) x 180 degree (n = 0, 1, 2, 3, ...). It is noted that at this time, the level adjusting means includes, for example, a first attenuator provided between the first hybrid set and the second magnetostatic filter and a second attenuator provided between the first magnetostatic wave filter and the second hybrid set.

While a ferrimagnetic substrate such as a YIG thin film is formed by growing a ferrimagnetic material such as YIG to form a wafer and by cutting the wafer, the ferrimagnetic substrate used for the first magnetostatic wave filter and the ferrimagnetic substrate used for the second magnetostatic wave filter are formed in a body in the present invention, so that the ferrimagnetic substrates used for the first magnetostatic wave filter and the second magnetostatic wave filter approach within the wafer and material characteristics such as a gyromagnetic resonance linewidth ΔH and a saturation magnetization 4πMs of the ferrimagnetic substrates approximate.

Further, because the ferrimagnetic substrate used for the first magnetostatic wave filter and the ferrimagnetic substrate used for the second magnetostatic wave filter are formed in a body so as to extend in the same direction with the propagation direction of the magnetostatic wave in those magnetostatic wave filters in the present invention, the ferrimagnetic substrates used for the first and second magnetostatic wave filters are disposed in the same direction with the direction of the parallel magnetic field and are applied with the same magnetic field.

As described above, the material characteristics of the ferrimagnetic substrates used for the first magnetostatic wave filter and the second magnetostatic wave filter approximate and the same magnetic field is applied to the ferrimagnetic substrates used for the first magnetostatic wave filter and the second magnetostatic wave filter in the present invention, so that the two magnetostatic wave filters having the same input/output characteristics may be simply constructed and a good enhancement characteristic may be readily obtained.

As described above, a signal-to-noise enhancer which can readily obtain a good enhancement characteristic may be constructed according to the present invention.

Further, because the ferrimagnetic substrate used for the first magnetostatic wave filter and the ferrimagnetic substrate used for the second magnetostatic wave filter are formed in a body for the signal-to-noise enhancer of the present invention, one ferrimagnetic substrate will do, thus improving the productivity.

In the present invention, when two transducers of the first magnetostatic wave filter are disposed at an interval on one end side of the ferrimagnetic substrate with respect to the longitudinal direction thereof, two transducers of the second magnetostatic wave filter are disposed at an interval on the other end side of the ferrimagnetic substrate with respect to the longitudinal direction thereof and a magnetostatic wave absorbing member for absorbing magnetostatic wave is formed at the middle portion of the ferrimagnetic substrate with respect to the longitudinal direction thereof by the reason described later, magnetostatic wave which might otherwise propagate from the first magnetostatic wave filter to the second magnetostatic wave filter and magnetostatic wave which might otherwise propagate from the second magnetostatic wave filter to the first magnetostatic wave filter are absorbed by the magnetostatic wave absorbing member, so that an interference which might otherwise caused by the magnetostatic wave between the first magnetostatic wave filter and the second magnetostatic wave filter may be prevented.

Further, when the present invention comprises the divider, provided in the pre-stage of the first magnetostatic wave filter and the second magnetostatic wave filter, for dividing the input signal into a first signal and a second signal, outputting the first signal to the first magnetostatic wave filter and outputting the second signal to the second magnetostatic wave filter; the combiner, provided in the post-stage of the first magnetostatic wave filter and the second magnetostatic wave filter, for combining two signals of the signal output from the first magnetostatic wave filter and the signal output from the second magnetostatic wave filter; the level adjusting means for equalizing levels of noises within the two signals combined by the combiner; and the phase adjusting means for adjusting phases of noises within the two signals to be opposite from each other, the levels of the noises within the two signals combined by the combiner are equalized by the level adjusting means and their phases being made to be opposite from each other by the phase adjusting means, those noises may be offset reliably. As a result, the signal-to-noise ratio may be improved further.

Further, when the present invention comprises the first hybrid set, provided in the pre-stage of the first magnetostatic wave filter and the second magnetostatic wave filter, for dividing the input signal into a first signal and a second signal having a first phase difference in a wide bandwidth, outputting the first signal to the first magnetostatic wave filter and outputting the second signal to the second magnetostatic wave filter; the second hybrid set, provided in the post-stage of the first magnetostatic wave filter and the second magnetostatic wave filter, for combining two signals of the signal output from the first magnetostatic wave filter and the signal output from the second magnetostatic wave filter with a second phase difference in a wide bandwidth; and the level adjusting means for equalizing levels of noises within the two signals combined by the second hybrid set; and the sum of the first phase difference and the second phase difference is (2n + 1) x 180 degree (n = 0, 1, 2, 3, ...), the phases of the two signals combined by the second hybrid set become opposite because the input signal is divided into the first signal and the second signal having the first phase difference in the wide bandwidth by the first hybrid set, the two signals of the signal output from the first magnetostatic wave filter and the signal output from the second magnetostatic wave filter are combined by the second hybrid set with the second phase difference in the wide bandwidth and the sum of the first phase difference and the second phase difference is (2n + 1) x 180 degree (n = 0, 1, 2, 3, ...). Further, the levels of noises within the two signals combined by the second hybrid set are equalized by the level adjusting means. As a result, the noises within the two signals combined by the second hybrid set are reliably offset. Accordingly, the signal-to-noise enhancer having a wide operating frequency bandwidth which is more than a desired enhancement. Further, because the operating frequency bandwidth of the signal-to-noise enhancer is wide, it is easy to adjust the operating frequency bandwidth so that a frequency to be used falls within the operating frequency bandwidth and it takes only a short time to adjust the operating frequency bandwidth, beside that the operating frequency bandwidth hardly deviates from the frequency to be actually used even if it fluctuates when a temperature changes.

The above and other objects, features and advantages of the present invention will become more apparent in the following detailed description of preferred embodiments made with reference to the drawings.

### BRIEF DESCRIPTION OF THE DRAWINGS

- FIG. 1: is a schematic plan view showing one embodiment of the present invention;
- FIG. 2: is a schematic section view showing a main part of the embodiment shown in FIG. 1;
- FIG. 3: is a plan view showing another embodiment of the present invention;
- FIG. 4: is a frontal view of the embodiment shown in FIG. 3;
- FIG. 5: is a plan view showing a main part of a first 90 degree hybrid set (second 90 degree hybrid set) used in the embodiment shown in FIG. 3;
- FIG. 6: is a circuit diagram showing a main part of the first 90 degree hybrid set (second 90 degree hybrid set) used in the embodiment shown in FIG. 3;
- FIG. 7: is a circuit diagram of the embodiment shown in FIG. 3; and
- FIG. 8: is a circuit diagram showing one example of a prior art signal-to-noise enhancer.

### DETAILED DESCRIPTION OF PREFERRED EMBODIMENTS

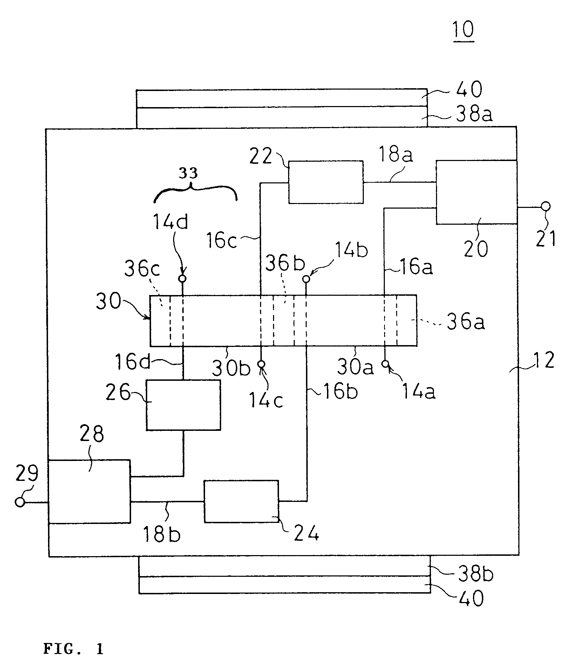

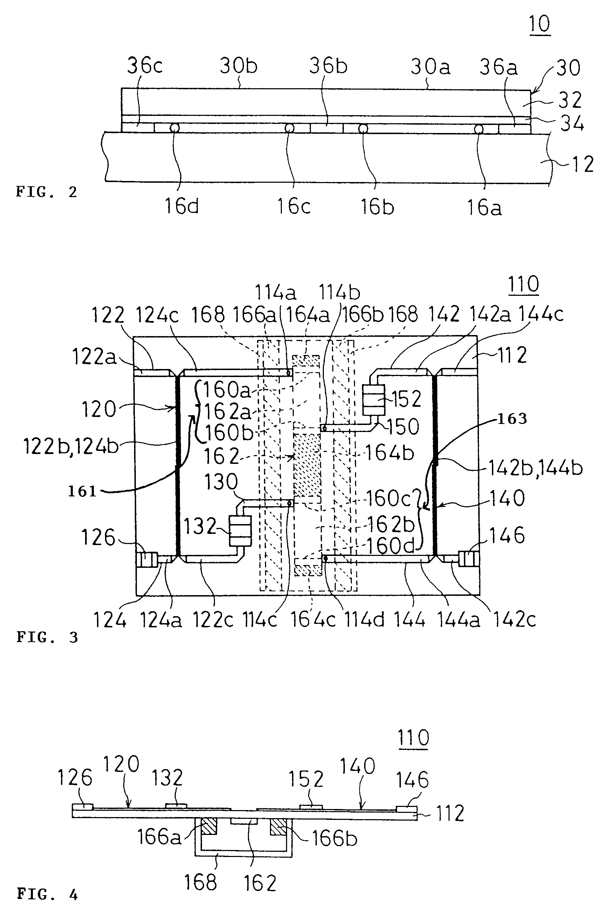

FIG. 1 is a schematic plan view showing one embodiment of the present invention and FIG. 2 is a schematic section view showing a main part thereof. This signal-to-noise enhancer 10 includes a rectangular substrate 12 made of a dielectric material such as synthetic resin and/or ceramics. Four through holes 14a, 14b, 14c and 14d are formed so as to line up alternately on the substrate 12.

Four transducers 16a, 16b, 16c and 16d composed of four line electrodes are formed in parallel at predetermined intervals on one main surface of the substrate 12. At this time, the four transducers 16a through 16d are formed so as to extend from the neighborhood of the four through holes 14a through 14d. Further, two drawing electrodes 18a and 18b are formed on the one main surface of the substrate 12.

Further, a divider 20, a first attenuator 22 composed of a resistor for example, a second attenuator 24 composed of a resistor for example, a phase shifter 26 composed of a delay line for example and a combiner 28 are mounted on the one main surface of the substrate 12.

The divider 20 divides an input signal applied to input 21 into a first and second output signal (each having about one half the level of the input signal) which appear at first and second outputs of the divider 20, respectively. The first output end of the divider 20 is connected to the transducer 16a. The second output end of the divider 20 is connected to an input end of the first attenuator 22 via the drawing electrode 18a.

The first attenuator 22 attenuates the second signal output from the second output of the divider 20 by, for example, 30 dB so that the level of that signal is substantially less than the level of the unattenuated first signal. An output end of the first attenuator 22 is connected with one end of the transducer 16c.

The second attenuator 24 attenuates the level of a signal input there by, for example, 30 dB. An input end of the second attenuator 24 is connected with one end of the transducer 16b. An output end of the second attenuator 24 is connected with a first input end of the combiner 28 via the drawing electrode 18b.

The phase shifter 26 adjusts the phase of a signal input there. An input end of the phase shifter 26 is connected with one end of the transducer 16d and an output end thereof is connected with a second input end of the combiner 28.

The combiner 28 combines the signal output from the second attenuator 24 with the signal output from the phase shifter 26. An output end of the combiner 28 is connected with an output terminal 29.

A magnetostatic wave element 30 is mounted on the four transducers 16a through 16d on the one main surface of the substrate 12. It is noted that the other ends of the four transducers 16a through 16d are grounded via the through holes 14a through 14d, respectively.

As shown in FIG. 2, the magnetostatic wave element 30 includes a strip GGG substrate 32, and a YIG thin film 34 as a ferrimagnetic substrate is formed on one main surface of the GGG substrate 32. The magnetostatic wave element 30 is mounted so that the surface of the YIG thin film 34 faces to one main surface of the substrate 12. At this time, the magnetostatic wave element 30 is mounted so that one end portion 30a thereof faces to the two transducers 16a and 16b and the other end portion 30b to the other two transducers 16c and 16d. It is noted that magnetostatic absorbing members 36a, 36b and 36c for absorbing unnecessary magnetostatic waves generated in the YIG thin film 34 are formed at one end, middle and other end portions of the surface of the YIG thin film 34 of the magnetostatic wave element 30 with respect to the longitudinal direction thereof, respectively.

Further, permanent magnets 38a and 38b made of a ferrite for example are mounted respectively on the both sides of the substrate 12, i.e. on the both sides of the magnetostatic wave element 30. At this time, the permanent magnets 38a and 38b are disposed so that a magnetic field is generated in the direction in which the transducers 16a through 16d extend. As a result, the magnetic field is applied to the magnetostatic wave element 30 in the direction in which the transducers 16a through 16d extend. Accordingly, the magnetostatic wave element 30 becomes a magnetostatic wave element utilizing a magnetostatic surface wave mode.

A first magnetostatic wave filter 31, including the two transducers 16a and 16b and the one end portion 30a of the magnetostatic wave element 30 has a frequency-selective nonlinear amplitude limiting characteristic. The first magnetostatic wave filter 31 limits an amplitude of a main signal within the first signal output from the first output end of the divider 20. At this time, one end of the transducer 16a is used as an input end and one end of the transducer 16b is used as an output end in the first magnetostatic wave filter 31.

A second magnetic wave filter 33, including the remaining two transducers 16c and 16d and the other end portion 30b of the magnetostatic wave element 30 also has a frequency-selection nonlinear amplitude limiting characteristic. Because this second magnetostatic wave filter 33 has a similar structure with the first magnetostatic wave filter 31, it has the same input/output characteristics with the first magnetostatic wave filter 31. The second magnetostatic wave filter 33 passes a signal input there. At this time, one end of the transducer 16c is used as an input end and one end of the transducer 16d is used as an output end in the second magnetostatic wave filter.

Accordingly, in the signal-to-noise enhancer 10 described above, a first signal path is composed of the divider 20, the first magnetostatic wave filter 31, the second attenuator 24 and the combiner 28 and a second signal path is composed of the divider 20, the first attenuator 22, the second magnetostatic wave filter 33, the phase shifter 26 and the combiner 28 between the input terminal 21 and the output terminal 29.

It is noted that a yoke 40 having a U-shaped section and made of a magnetic substance is preferably mounted outside of the permanent magnets 38a and 38b so as to cover the magnetostatic wave element 30 and the magnets 38a and 38b. The yoke 40 reduces a magnetic resistance between the magnets 38a and 38b and protects the magnetostatic wave element 30 and the magnets 38a and 38b.

Further, screws (not shown) made of a magnetic substance for adjusting a scale and distribution of the magnetic field applied to the magnetostatic wave element 30 are provided in the neighborhood of the magnets 38a and 38b.

An operation of the signal-to-noise enhancer 10 constructed as described above will be explained below.

In the signal-to-noise enhancer 10, when an input signal containing a main signal and noise whose frequency differs from that of the main signal and whose level is lower is input to the input terminal 21, it is divided by the divider 20 into a first signal and a second signal. At this time, the input signal is divided into the first signal having a level half of that of the input signal and the second signal at the first output end and the second output end of the divider 20. The first signal and the second signal have a main signal and noise whose level is low, respectively.

The main signal within the first signal is amplitude limited by the first magnetostatic wave filter 31. In contrary, because the noise within the first signal is different from th main signal in frequency and its level is low, it is not amplitude limited by the first magnetostatic wave filter. It is noted that the level of the first signal attenuates slightly due to insertion loss of the first magnetostatic wave filter 31. At this time, a magnetostatic surface wave propagates from the transducer 16a to the transducer 16b in the one end portion 30a of the magnetostatic wave element 30.

The level of the second signal appearing at the second output of the divider 20 is attenuated by 30 dB by the first attenuator 22. Because the level of the second signal which has been attenuated is low, it passes the second magnetostatic wave filter 33 without being amplitude limited. It is noted that the level of the attenuated second signal attenuates slightly due to insertion loss of the second magnetostatic wave filter 33. At this time, a magnetostatic surface wave propagates from the transducer 16c to the transducer 16d in the other end portion 30b of the magnetostatic wave element 30.

The second attenuator 24 attenuates a level of the signal output from the first magnetostatic wave filter 31 by 30 dB. Further, the phase shifter 26 adjusts a phase of the signal output from the second magnetostatic wave filter 33.

Then, the signal output from the second attenuator 24 and the signal output from the phase shifter 26 are combined by the combiner 28. At this time, the levels of noises within the two signals in the first and second signal paths combined by the combiner 28 are equalized by the first attenuator 22 and the second attenuator 24 as level adjusting means. Further, phases of the two signals in the first and second signal paths combined by the combiner 28 are made to be opposite from each other by the phase shifter 26 as phase adjusting means. It should be noted that the phases of those two signals may be adjusted by adjusting the scale and distribution of the magnetic field applied to the magnetostatic wave element 30 by the screws made of a magnetic substance provided in the neighborhood of the permanent magnets 38a and 38b. Accordingly, the noise within the two signals in the first and second signal paths combined by the combiner 28 are reliably offset. Further, the main signal which corresponds to the level amplitude limited by the first magnetostatic wave filter is obtained from the output end of the combiner 28 or from the output terminal 29.

In the signal-to-noise enhancer 10 described above, while the YIG thin film 34 as the ferrimagnetic substrate is formed by forming a wafer by growing YIG as a ferrimagnetic material and by cutting the wafer, the ferrimagnetic substrate used for the first magnetostatic wave filter and the ferrimagnetic substrate used for the second magnetostatic wave filter are formed in a body, so that the ferrimagnetic substrates used for the first magnetostatic wave filter and the second magnetostatic wave filter approach within the wafer and material characteristics such as a gyromagnetic resonance linewidth _H and a saturation magnetization 4πMs of the ferrimagnetic substrates approximate.

Further, because the ferrimagnetic substrate used for the first magnetostatic wave filter and the ferrimagnetic substrate used for the second magnetostatic wave filter are formed in a body so as to extend in the same direction with the propagation direction of the magnetostatic wave in those magnetostatic wave filters in the signal-to-noise enhancer 10, the ferrimagnetic substrates used for the first and second magnetostatic wave filters 31, 33 are disposed in the same direction with the direction of the parallel magnetic field generated by the permanent magnets 38a and 38b and are applied with the same magnetic field.

As described above, the magnetic characteristics of the ferrimagnetic substrates used for the first magnetostatic wave filter 31 and the second magnetostatic wave filter approximate and the same magnetic field is applied to the ferrimagnetic substrates used for the first magnetostatic wave filter 31 and the second magnetostatic wave filter 33 in the signal-to-noise enhancer 10, so that the first magnetostatic wave filter and the second magnetostatic wave filter having the same input/output characteristics may be simply constructed and a good enhancement characteristic may be readily obtained.

Further, because the ferrimagnetic substrate used for the first magnetostatic wave filter 31 and the ferrimagnetic substrate used for the second magnetostatic wave filter 33 are formed in a body for the signal-to-noise enhancer 10, one ferrimagnetic substrate will do and the ferrimagnetic substrate can be cut out and handled readily, thus improving the productivity.

Still more, because the magnetostatic wave absorbing member 36b for absorbing the magnetostatic wave is formed in the middle portion of the YIG thin film 34 with respect to the longitudinal direction thereof, i.e. between the transducers 16a and the transducer 16b of the first magnetostatic wave filter 31 and the transducers 16c and 16d of the second magnetostatic wave filter 33, a magnetostatic wave to be propagated from the first magnetostatic wave filter 31 to the second magnetostatic wave filter 33 and a magnetostatic wave to be propagated from the second magnetostatic wave filter 33 to the first magnetostatic wave filter 31 are absorbed by the magnetostatic wave absorbing member, thus preventing an interference which might be otherwise caused by the magnetostatic wave between the first magnetostatic wave filter 31 and the second magnetostatic wave filter 33.

Further, because the magnetostatic wave absorbing members 36a and 36c for absorbing magnetostatic waves are formed at one end and other end portions of the YIG thin film 34 with respect to the longitudinal direction thereof in the signal-to-noise enhancer 10, unnecessary magnetostatic wave reflected by the both end portions of the YIG thin film 34 with respect to the longitudinal direction thereof may be absorbed.

It is noted that because the signal-to-noise enhancer 10 uses the magnetostatic wave element utilizing the magnetostatic surface wave mode for the first magnetostatic wave filter, it can enhance the signal-to-noise ratio of the input signal even if the lowest level of the main signal amplitude limited by the first magnetostatic wave filter 31, i.e. the saturation level of the first magnetostatic wave filter 31, is low and the level of the main signal is low.

FIG. 3 is a plan view showing another embodiment of the present invention and FIG. 4 is a front view thereof. This enhancer 110 includes a rectangular substrate 112 made of a dielectric material such as synthetic resin and/or ceramics.

Four through holes 114a, 114b, 114c and 114d are created on the substrate 112. At this time, the two through holes 114a and 114c are created a little off to one end from the center of the substrate 112 with respect to the longitudinal direction thereof and the other two through holes 114b and 114d are created a little off to the other end from the center of the substrate 112 with respect to the longitudinal direction thereof. The through hole 114a is created in the neighborhood of one long side of the substrate 112, the through hole 114b is created a little off to the one long side from the center of the substrate 112, the through hole 114c is created a little off to the other long side from the center of the substrate 112 and the through hole 114d is created in the neighborhood of the other long side of the substrate 112.

A first 90 degree hybrid set 120 for example as a first hybrid set is created on one main surface of the substrate 112 from one end of the substrate 112 with respect to the longitudinal direction thereof to the center. The first 90 degree hybrid set 120 includes two cranked line electrodes 122 and 124.

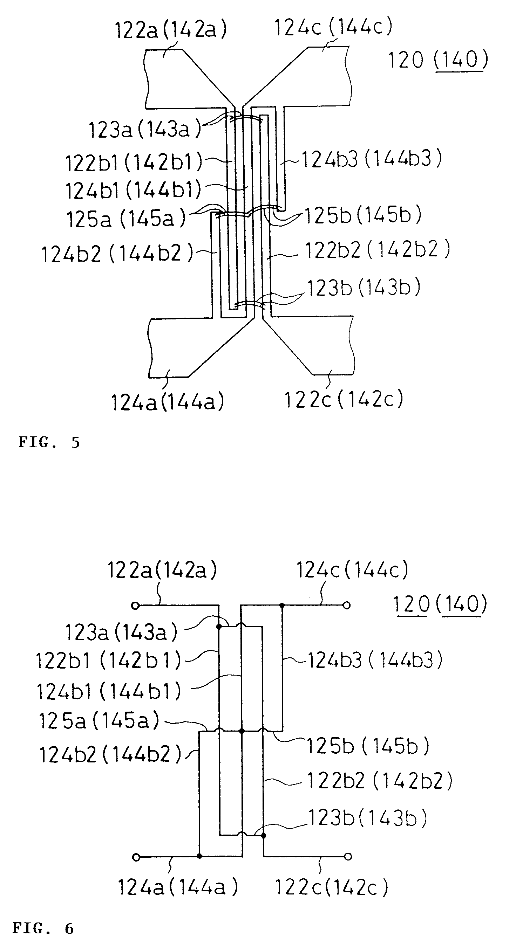

One line electrode 122 consists of a wide end portion 122a extending along one long side from one end of the substrate 112 with respect to the longitudinal direction thereof, an intermediate portion 122b extending along the short side of the substrate 112 and another wide end portion 122c extending along the other long side of the substrate 112. As shown in FIGs. 5 and 6, the intermediate portion 122b of the line electrode 122 includes two thin line portions 122b1 and 122b2 disposed in parallel from each other at an interval.

One line portion 122b1 is formed so as to extend from one end portion 122a and the other line portion 122b2 is formed so as to extend from the other end portion 122c. Both ends of one line portion 122b1 are connected with both ends of the other line portion 122b2 by two U-shaped lead wires 123a and 123b such as gold wires and aluminum wires, for example, by wire bonding.

The other line electrode 124 consists of a wide end portion 124a extending along the other long side from one end of the substrate 112 with respect to the longitudinal direction thereof, an intermediate portion 124b extending along the short side of the substrate 112 and another wide end portion 124c extending along one long side of the substrate 112 as shown in FIG. 3. As shown in FIGs. 5 and 6, the intermediate portion 124b of the line electrode 124 includes three thin line portions 124b1, 124b2 and 124b3 disposed in parallel each other at intervals. One line portion 124b1 is formed so as to extend from one end portion 124a to the other end portion 124c between the two line portions 122b1 and 122b2 of the line electrode 122. The other two line portion 124b2 and 124b3 are formed so as to extend from one end portion 124a and the other end portion 124c outsides of the line portions 122b1 and 122b2 in half length of the line portion 124b1. The end of the line portions 124b and 124b3 are electrically connected to the center of the line portion 124b1 by two U-shaped lead wires 125a and 125b such as gold wires and aluminum wires, for example, by wire bonding.

As shown in FIG. 3, one end of a resistor 126 of 50 ohm for example as a terminator is connected to the end portion 124a of the line electrode 124. The other end of the resistor 126 is grounded.

The first 90 degree hybrid set 120 divides an input signal including a main signal and noise into a first signal and a second signal having a phase difference of 90 degree in a wide bandwidth of 1.4 MHz to 2.4 MHz for example. At this time, in the first 90 degree hybrid set 120, the one end portion 122a of the line electrode 122 is used as an input end, the other end portion 124c of the line electrode 124 is used as a first output end and the other end portion 122c of the line electrode 122 is used as a second output end. Then, the input signal input to the input end is divided into the first signal having a half level of the input signal and a second signal, at the first and second output ends. It is noted that the phase of the second signal is delayed from that of the first signal by 90 degree.

Further, an L-shaped drawing electrode 130 is formed from the neighborhood of the end portion 122c of the line electrode 122 of the first 90 degree hybrid set 120 to the neighborhood of the through hole 114c. Then, both ends of a resistor 132 of 50 ohm for example as a first attenuator are connected to the other end portion 122c and the drawing electrode 130, respectively. The resistor 132 attenuates the level of the second signal output from the second output end of the first 90 degree hybrid set 120 by 30 dB for example.

Further, a second 90 degree hybrid set 140 for example as a second hybrid set is created on one main surface of the substrate 112 from the center to the other end of the substrate 112 with respect to the longitudinal direction thereof. The second 90 degree hybrid set 140 has the same structure with the first 90 degree hybrid set 120. That is, the second 90 degree hybrid set 140 includes two cranked line electrodes 122 and 124.

One line electrode 142 consists of a wide end portion 142a extending along one long side of the substrate 112, an intermediate portion 142b extending along the short side of the substrate 112 and another wide end portion 142c extending along the other long side of the substrate 112. As shown in FIGs. 5 and 6, the intermediate portion 142b of the line electrode 142 includes two thin line portions 142b1 and 142b2 disposed in parallel each other at an interval. One line portion 142b1 is formed so as to extend from one end portion 142a and the other line portion 142b2 is formed so as to extend from the other end portion 142c. Both ends of one line portion 142b1 are connected with both ends of the other line portion 142b2 by two U-shaped lead wires 143a and 143b such as gold wires and aluminum wires, for example, by wire bonding.

The other line electrode 144 consists of a wide end portion 144a extending along the other long side of the substrate 112 from the neighborhood of the through hole 114d, an intermediate portion 144b extending in parallel with the short side of the substrate 112 and another wide end portion 144c extending along one long side of the substrate 112 as shown in FIG. 3. As shown in FIGs. 5 and 6, the intermediate portion 144b of the line electrode 144 includes three thin line portions 144b1, 144b2 and 144b3 disposed in parallel each other at intervals. One line portion 144b1 is formed so as to extend from one end portion 144a to the other end portion 144c between the two line portions 142b1 and 142b2 of the line electrode 142. The other two line portion 144b2 and 144b3 are formed so as to extend from one end portion 144a and the other end portion 144c outsides of the line portions 142b1 and 142b2 in half length of the line portion 144b1. The end of the line portions 144b and 144b3 are electrically connected to the center of the line portion 144b1 by two U-shaped lead wires 145a and 145b such as gold wires and aluminum wires, for example, by wire bonding.

As shown in FIG. 3, one end of a resistor 146 of 50 ohm for example as a terminator is connected to the other end portion 142c of the line electrode 142. The other end of the resistor 146 is grounded.

The second 90 degree hybrid set 140 described above combines two input signals with a phase difference of 90 degree in a wide bandwidth of 1.4 MHz to 2.4 MHz for example. At this time, in the second 90 degree hybrid set 140, the one end portion 142a of the line electrode 142 is used as a first input end, one end portion 144a of the line electrode 144 is used and a second input end and the other end portion 144c of the line electrode 144 is used as an output end. Then, two signals input to the first and second input ends of the second 90 degree hybrid set 140 are combined at the output end. It is noted that when two signals are combined, the phase of the signal input to the second input end is delayed from that of the signal input to the second input end by 90 degree.

Further, an L-shaped drawing electrode 150 is formed from the neighborhood of the end portion 142a of the line electrode 142 of the second 90 degree hybrid set 140 to the neighborhood of the through hole 114b. Then, both ends of a resistor 152 of 50 ohm for example as a second attenuator are connected to one end portion 142a and the drawing electrode 150, respectively. The resistor 152 attenuates the level of the signal input to the first input end of the second 90 degree hybrid set 140 by 30 dB for example.

Four transducers 160a, 160b, 160c and 160d composed of four line electrodes are formed in parallel with the long side of the substrate 112 from the neighborhood of the through holes 114a, 114b, 114c and 114d at the center in the longitudinal direction of the other main surface of the substrate 112. At this time, one end of the four transducers 160a through 160d are electrically connected to the other end portion 124c of the line electrode 124, the drawing electrode 150, the drawing electrode 130 and one end portion 144a of the line electrode 144, respectively, via the through holes 114a, 114b, 114c and 114d. Further, the other ends of those transducers 160a through 160d are grounded, respectively.

A magnetostatic wave element 162 is mounted on the four transducers 160a through 160d on the other main surface of the substrate 112.

This magnetostatic wave element 162 includes a strip GGG substrate, and a YIG thin film as a ferrimagnetic substrate is formed on one main surface of the GGG substrate. The magnetostatic wave element 162 is mounted so that the surface of the YIG thin film faces to the other main surface of the substrate 112. At this time, the magnetostatic wave element 162 is mounted so that one end portion 162a thereof faces to the two transducers 160a and 160b and the other end portion 162b faces to the other two transducers 160c and 160d. It is noted that magnetostatic absorbing members 164a, 164b and 164c for absorbing unnecessary magnetostatic waves generated in the YIG thin film are formed at one end, middle and other end portions of the surface of the YIG thin film of the magnetostatic wave element 162 with respect to the longitudinal direction thereof, respectively.

Further, permanent magnets 166a and 166b made of ferrite for example are mounted respectively on the both sides of the substrate 112, i.e. on the both sides of the magnetostatic wave element 162. At this time, the permanent magnets 166a and 166b are disposed so that a magnetic field is generated in the direction in which the transducers 160a through 160d extend. Due to that, the magnetic field is applied to the magnetostatic wave element 162 in the direction in which the transducers 160a through 160d extend. Accordingly, the magnetostatic wave element 162 becomes a magnetostatic wave element utilizing a magnetostatic surface wave mode.

A first magnetostatic wave filter 161, which includes the two transducers 160a and 160b, the one end portion 162a of the magnetostatic wave element 162 and the like are used as a first magnetostatic wave filter. This first magnetostatic wave filter has a frequency-selective nonlinear amplitude limiting characteristic. The first magnetostatic wave filter 161 limits an amplitude of a main signal within the first signal output from the first output end of the first 90 degree hybrid set 120. At this time, one end of the transducer 160a is used as an input end and one end of the transducer 160b is used as an output end in the first magnetostatic wave filter 161.

A second magnetostatic wave filter 163, which includes the other two transducers 160c and 160d, the other end portion 162b of the magnetostatic wave element 162 and the like are used as a second magnetostatic wave filter. Because this second magnetostatic wave filter has a similar structure with the first magnetostatic wave filter 161 described above, it has the same input/output characteristics with the first magnetostatic wave filter. The second magnetostatic wave filter 163 passes a signal input there. At this time, one end of the transducer 160c is used as an input end and one end of the transducer 160d is used as an output end in the second magnetostatic wave filter 163.

It is noted that a yoke 168 having a U-shaped section and made of a magnetic substance is preferably mounted so as to cover the magnetostatic wave element 162 and the magnets 166a and 166b on the other main surface of the substrate 112. The yoke 168 reduces a magnetic resistance between the magnets 166a and 166b and protects the magnetostatic wave element 162 and the magnets 166a and 166b.

Accordingly, the signal-to-noise enhancer 110 has a circuit as shown in FIG. 7. That is, in the signal-to-noise enhancer 110, the first output end of the first 90 degree hybrid set 120 is connected to the input end of the first magnetostatic wave filter 161 using the one end portion 162a of the magnetostatic wave element 162. Further, the second output end of the first 90 degree hybrid set 120 is connected to the input end of the second magnetostatic wave filter 163 using the other end portion 162b of the magnetostatic wave element 162 via the resistor 132 as a first attenuator. Further, the output end of the first magnetostatic wave filter 161 is connected to the first input end of the second 90 degree hybrid set 140 via the resistor 152 as a second attenuator. The output end of the second magnetostatic wave filter 163 is connected to the second input end of the second 90 degree hybrid set 140.

Then, in the signal-to-noise enhancer 110 described above, a first signal path is composed of the first 90 degree hybrid set 120, the first magnetostatic wave filter 161 including the one end portion 162a of the magnetostatic wave element 162 and the like, the second attenuator composed of the resistor 152 and the second 90 degree hybrid set 140 and a second signal path is composed of the first 90 degree hybrid set 120, the first attenuator composed of the resistor 132, the second magnetostatic wave filter 163 including the other end portion 162b of the magnetostatic wave element 162 and the like and the second 90 degree hybrid set 140.

An operation of the signal-to-noise enhancer 110 described above will be explained below.

In the signal-to-noise enhancer 110, when an input signal containing a main signal and noise whose frequency differs from that of the main signal and whose level is lower is input to the input end of the first 90 degree hybrid set 120, i.e. to the one end portion 122a of the line electrode 122, it is divided by the first 90 degree hybrid set 120 into a first signal and a second signal having a phase difference of 90 degree in a wide bandwidth of 1.4 MHz to 2.4 MHz. At this time, the input signal is divided into the first signal having a level half of that of the input signal and the second signal, at the first output end and the second output end of the first 90 degree hybrid set 120. The first signal and the second signal have a main signal and noise whose level is low, respectively. Further, the phase of the first signal is delayed from that of the second signal by 90 degree.

The main signal within the first signal is amplitude limited by the first magnetostatic wave filter including the one end portion 162a of the magnetostatic wave element 162 and the like. In contrary, because the noise within the first signal is different from the main signal in frequency and its level is low, it is not amplitude limited by the first magnetostatic wave filter. It is noted that the level of the first signal attenuates slightly due to insertion losses of the first magnetostatic wave filter 161. At this time, a magnetostatic surface wave propagates from the transducer 160a to the transducer 160b in the one end portion 162a of the magnetostatic wave element 162.

The level of the second signal is attenuated preferably by 30 dB by the first attenuator 22 composed of the resistor 132. Because the level of the second signal which has been attenuated is low, it passes the second magnetostatic wave filter 163 without being amplitude limited. It is noted that the level of the attenuated second signal attenuates slightly due to insertion losses of the second magnetostatic wave filter 163. At this time, a magnetostatic surface wave propagates from the transducer 160c to the transducer 160d in the other end portion 162b of the magnetostatic wave element 162.

The second attenuator 24 attenuates the level of the signal output from the first magnetostatic wave filter by preferably 30 dB.

Then, the signal output from the second attenuator and the signal output from the second magnetostatic wave filter 163 are combined by the second 90 degree hybrid set 140 while having the phase difference of 90 degree in the wide bandwidth of 1.4 MHz to 2.4 MHz. At this time, the levels of noises within the two signals in the first and second signal paths combined by the second 90 degree hybrid set 140 are equalized by the first and second attenuators as level adjusting means. Further, the phase difference of the two signals in the first and second signal paths combined by the second 90 degree hybrid set 140 are made to be 180 degree, i.e. an opposite phase, in the wide bandwidth by the first 90 degree hybrid set 120 and the second 90 degree hybrid set 140. Accordingly, the noises within the two signals in the first and second signal paths combined by the second 90 degree hybrid set 140 are offset in the wide bandwidth. Further, the main signal which corresponds to the level amplitude limited by the first magnetostatic wave filter 161 is obtained from the output end of the second 90 degree hybrid set 140.

Similarly to the signal-to-noise enhancer 10 described before, the ferrimagnetic substrate used for the first magnetostatic wave filter 161 and the ferrimagnetic substrate used for the second magnetostatic wave filter 163 are formed in a body so as to extend in the same direction with the propagation direction of the magnetostatic wave in those magnetostatic wave filters also in this signal-to-noise enhancer 110, so that the first magnetostatic wave filter 161 and the second magnetostatic wave filter 163 having the same input/output characteristics may be readily constructed, a good enhancement characteristic may be readily obtained, the ferrimagnetic substrate can be cut out and handled readily and then the productivity is improved.

Still more, because the magnetostatic wave absorbing member 164b is formed at the middle portion of the YIG thin film with respect to the longitudinal direction thereof also in this signal-to-noise enhancer 110, an interference which might be otherwise caused by magnetostatic waves between the first magnetostatic wave filter 161 and the second magnetostatic wave filter 163 can be prevented.

Further, the magnetostatic wave absorbing members 164a and 164c are formed at one end and other end portions of the YIG thin film with respect to the longitudinal direction thereof in the signal-to-noise enhancer 110, unnecessary magnetostatic wave reflected by the both end portions of the YIG thin film with respect to the longitudinal direction thereof may be absorbed.

It is noted that because the signal-to-noise enhancer 110 uses a magnetostatic wave element utilizing the magnetostatic surface wave mode for the first magnetostatic wave filter, it can enhance the signal-to-noise ratio of the input signal even if the lowest level of the main signal amplitude limited by the first magnetostatic wave filter 161, i.e. the saturation level of the first magnetostatic wave filter 161, is low and the level of the main signal is also low.

It is also noted that because the phases of the two signals in the first and second signal paths combined by the second 90 degree hybrid set 140 become opposite from each other in the wide bandwidth in the signal-to-noise enhancer 110, an operating frequency bandwidth which is more than a desired enhancement can be obtained in a wide bandwidth.

Further, because the operating frequency bandwidth of the signal-to-noise enhancer 110 is wide, it is easy to adjust the operating frequency bandwidth so that a frequency to be used falls within the operating frequency bandwidth and it takes only a short time to adjust the operating frequency bandwidth, beside that the operating frequency bandwidth hardly deviates from the frequency to be actually used even if it fluctuates when a temperature changes.

Still more, because the 90 degree hybrid sets are used respectively as the first hybrid set and the second hybrid set in the signal-to-noise enhancer 110, the same hybrid set may be fabricated as the first hybrid set and the second hybrid set, thus improving the efficiency for fabricating the first hybrid set and the second hybrid set.

It is noted that although the magnetostatic wave element utilizing the magnetostatic surface wave mode having a band-pass function has been used as the first magnetostatic wave filter 161 and the second magnetostatic wave filter 163 in each embodiment described above, it is possible to use a magnetostatic wave element utilizing a magnetostatic forward volume wave mode or a magnetostatic backward volume wave mode or a filter such as a low-pass filter using magnetostatic wave, a high-pass filter using magnetostatic wave and a band elimination filter using magnetostatic wave.

Further, although the YIG thin film has been used as the ferrimagnetic substrate in each embodiment described above, it is possible to use a ferrimagnetic substrate other than the YIG thin film in the present invention.

Still more, each of the transducers is formed by one linear line in each embodiment described above, the shape and the number of lines composing each transducer may be arbitrarily changed. Further, it is not necessary to match the size of each transducer with the size of the YIG thin film.

Although the permanent magnets have been used to apply a magnetic field to the YIG thin film in each embodiment described above, electromagnets can be used instead of the permanent magnets or the electromagnets may be used together with the permanent magnets.

Although the magnetic field has been applied to the YIG thin film in the direction in which the transducers extend in each embodiment described above, it is possible to apply the magnetic field to the YIG thin film in the direction perpendicular to the main surface thereof. In this case, a volume advancing magnetostatic wave propagates in the YIG thin film with respect to the longitudinal direction thereof. Or, it is possible to apply the magnetic field to the YIG thin film with respect to the longitudinal direction thereof. In this case, a volume retreating magnetostatic wave propagates in the YIG thin film with respect to the longitudinal direction thereof.

Further, the first and second attenuators have been used as the level adjusting means in each embodiment described above, it is possible to provide an attenuator in the pre-stage of the combiner and the first hybrid set, to provide an amplifier in the pre-stage of the first magnetostatic wave filter and to provide an amplifier in the post-stage of the second magnetostatic wave filter, instead of the first and second attenuators. Or, it is possible to provide amplifiers and attenuators in the pre-stage of the combiner and the first hybrid set, in the pre-stage of and in the post-stage of the first magnetostatic wave filter and in the pre-stage of and in the post-stage of the second magnetostatic wave filter, respectively.

It is also possible to create a groove at the center of the YIG thin film, instead of forming the magnetostatic wave absorbing member at the center of the YIG thin film with respect to the longitudinal direction thereof, to prevent the interference which might be otherwise caused by the magnetostatic wave between the first magnetostatic wave filter and the second magnetostatic wave filter.

It is noted that it is preferable to dispose the transducer on the input side of the second magnetostatic wave filter to which a low level signal is input at the center of the YIG thin film with respect to the longitudinal direction thereof as described in each embodiment in order to suppress the interference caused by the magnetostatic wave between the first magnetostatic wave filter and the second magnetostatic wave filter by the following reason. That is, it is preferable to equalize the propagation directions of the magnetostatic waves in the first magnetostatic wave filter and the second magnetostatic wave filter in order to propagate them efficiently and in that case, the transducer on the input side of one fm among the first magnetostatic wave filter and the second magnetostatic wave filter is disposed at the center of the YIG thin film. If the transducer on the input side of the second magnetostatic wave filter to which a low-level signal is input is disposed at the center of the YIG thin film, the transducer on the input side of the first magnetostatic wave filter to which a high-level signal is input can be kept away from the transducer of the second magnetostatic wave filter.

To prevent an adverse effect caused by unnecessary magnetostatic wave reflected at the both ends of the YIG thin film with respect to the longitudinal direction thereof, it is possible to form the both end portions of the YIG thin film with respect to the longitudinal direction thereof aslant so that no unnecessary magnetostatic wave is reflected to the transducers, instead of forming the magnetostatic wave absorbing members at the both ends of the YIG thin film.

It is noted that the 90 degree hybrid sets have been used as the first hybrid set and the second hybrid set in the embodiment shown in FIG. 3, it is possible to use 0 degree hybrid set and 180 degree hybrid set or 180 degree hybrid set and 0 degree hybrid set in the present invention. It is noted that the 0 degree hybrid set or the 180 degree hybrid set may be constructed by using two 90 degree hybrid sets by taking their phase difference into consideration.

It is also noted that "90 degree" or "180 degree" described in the present invention shall contain substantially the same range in terms of the objects, operations and effects of the present invention centering on the literal values.

While preferred embodiments have been described, variations thereto will occur to those skilled in the art within the scope of the present inventive concepts which are delineated by the following claims.

## Claims

1. A signal-to-noise enhancer (10; 110), comprising:
a first magnetostatic wave filter (16a, 16b, 30a; 160a, 160b, 162a) for limiting an amplitude of a main signal within an input signal; and
a second magnetostatic wave filter (16c, 16d, 30b; 160c, 160d, 162b) for passing said main signal;
characterized in
that a ferrimagnetic substrate (34; 162) used for said first magnetostatic wave filter (16a, 16b, 30a; 160a, 160b, 162a) and a ferrimagnetic substrate (34; 162) used for said second magnetostatic wave filter (16c, 16d, 30b; 160c, 160d, 162b) are formed in a body so as to extend in the same direction with a propagation direction of magnetostatic waves in said first magnetostatic wave filter (16a, 16b, 30a; 160a, 160b, 162a) and said second magnetostatic wave filter (16c, 16d, 30b; 160c, 160d, 162b).

2. The signal-to-noise enhancer (10; 110) according to Claim 1, wherein:
two transducers of said first magnetostatic wave filter (16a, 16b, 30a; 160a, 160b, 162a) are disposed at an interval on one end side of said ferrimagnetic substrate (34; 162) with respect to the longitudinal direction thereof;
two transducers (16c, 16d; 160c; 160d) of said second magnetostatic wave filter (16c, 16d, 30b; 160c, 160d, 162b) are disposed at an interval on the other end side (30a; 162a) of said ferrimagnetic substrate (34; 162) with respect to the longitudinal direction thereof; and
a magnetostatic wave absorbing member (36b; 164b) for absorbing magnetostatic wave is formed at the middle portion of said ferrimagnetic substrate (34; 162) with respect to the longitudinal direction thereof.

3. The signal-to-noise enhancer (10; 110) according to Claim 1 or 2, comprising:
a divider (20; 120), provided in the pre-stage of said first magnetostatic wave filter (16a, 16b, 30a; 160a, 160b, 162a) and said second magnetostatic wave filter (16c, 16d, 30b; 160c, 160d, 162b), for dividing said input signal into a first signal and a second signal, outputting said first signal to said first magnetostatic wave filter (16a, 16b, 30a; 160a, 160b, 162a) and outputting said second signal to said second magnetostatic wave filter (16c, 16d, 30b; 160c, 160d, 162b);
a combiner (28; 140), provided in the post-stage of said first magnetostatic wave filter (16a, 16b, 30a; 160a, 160b, 162a) and said second magnetostatic wave filter (16c, 16d, 30b; 160c, 160d, 162b), for combining two signals of the signal output from said first magnetostatic wave filter (16a, 16b, 30a; 160a, 160b, 162a) and the signal output from said second magnetostatic wave filter (16c, 16d, 30b; 160c, 160d, 162b);
level adjusting means (22, 24; 132, 152) for equalizing levels of noises within said two signals combined by said combiner (28; 140); and
phase adjusting means (26; 120, 140) for adjusting phases of noises within said two signals to be opposite from each other.

4. The signal-to-noise enhancer (10) according to Claim 3, wherein
said level adjusting means (22, 24) includes a first attenuator (22) provided between said divider (20) and said second magnetostatic wave filter (16c, 16d, 30b) and a second attenuator (24) provided between said first magnetostatic wave filter (16a, 16b, 30a) and said combiner (28); and
said phase adjusting means (26) includes a phase shifter (26) provided between said second magnetostatic wave filter (16a, 16b, 30a) and said combiner (28).

5. The signal-to-noise enhancer (110) according to Claim 1 or 2, comprising:
a first hybrid set (120), provided in the pre-stage of said first magnetostatic wave filter (160a, 160b, 162a) and said second magnetostatic wave filter (160c, 160d, 162b), for dividing said input signal into a first signal and a second signal having a first phase difference in a wide bandwidth, outputting said first signal to said first magnetostatic wave filter (160a, 160b, 162a) and outputting said second signal to said second magnetostatic wave filter (160c, 160d, 162b);
a second hybrid set (140), provided in the post-stage of said first magnetostatic wave filter (160a, 160b, 162a) and said second magnetostatic wave filter (160c, 160d, 162b), for combining two signals of the signal output from said first magnetostatic wave filter (160a, 160b, 162a) and the signal output from said second magnetostatic wave filter (160c, 160d, 162b) with a second phase difference in a wide bandwidth; and
level adjusting means (132, 152) for equalizing levels of noises within said two signals combined by said second hybrid set (140);
a sum of said first phase difference and said second phase difference being (2n + 1) x 180 degree (n = 0, 1, 2, 3, ...).

6. The signal-to-noise enhancer (110) according to Claim 5, wherein
said level adjusting means (132, 152) includes a first attenuator (132) provided between said first hybrid set (120) and said second magnetostatic wave filter (160c, 160d, 162b) and a second attenuator (152) provided between said first magnetostatic wave filter (160a, 160b, 162a) and said second hybrid set (140).
